# EUROPÄISCHE PATENTSCHRIFT

(11) **EP 2 783 078 B1**
(45) Veröffentlichungstag und Bekanntmachung des Hinweises auf die Patenterteilung: **28.10.2015**
(21) Anmeldenummer: 12788487.2
(22) Anmeldetag: 07.11.2012
(51) Int. Cl.: F01D 25/00, F01D 25/26, C23C 16/00, C23C 4/00, C23C 14/00, F04D 29/08, F16L 23/032

(54) **VERFAHREN ZUR HERSTELLUNG EINER STRÖMUNGSMASCHINENKOMPONENTE MIT TEILFUGE UND DAMPFTURBINE MIT DER STRÖMUNGSMASCHINENKOMPONENTE**
METHOD FOR MANUFACTURING A TURBOMACHINE COMPONENT WITH A PARTING JOINT, AND A STEAM TURBINE COMPRISING SAID TURBOMACHINE COMPONENT
PROCÉDÉ DE FABRICATION DE COMPOSANTES DE TURBOMACHINES COMPRENANT UN JOINT DE SÉPARATION ET TURBINE À VAPEUR COMPRENANT LES COMPOSANTES DE TURBOMACHINES

(30) Priorität: 02.02.2012 EP 12153626
(43) Veröffentlichungstag der Anmeldung: 01.10.2014
(73) Patentinhaber: Siemens Aktiengesellschaft, 80333 München (DE)
(72) Erfinder: SCHÜRHOFF, Jörg, 45479 Mülheim a.d. Ruhr (DE)
(86) Internationale Anmeldenummer: PCT/EP2012/071993
(87) Internationale Veröffentlichungsnummer: WO 2013/113416

(56) Entgegenhaltungen:
- EP-A1- 2 410 137
- WO-A1-2010/026077
- JP-A- 2011 085 065
- US-A- 5 511 941
- US-A1- 2007 284 828

## Beschreibung

Die Erfindung betrifft ein Verfahren zur Herstellung einer Strömungsmaschinenkomponente mit einer Teilfuge und eine Dampfturbine mit der Strömungsmaschinenkomponente.

Eine Strömungsmaschine, wie z.B. eine Dampfturbine, weist ein Gehäuse auf, in dem ein Rotor der Dampfturbine gelagert ist. Damit das Gehäuse geöffnet werden kann, um beispielsweise den Rotor aus dem Gehäuse zu nehmen, weist es eine horizontale Teilfuge auf, so dass das Gehäuse in ein Unterteil und ein Oberteil zweigeteilt ist. Um eine Leckage des Wasserdampfs an der Teilfuge zu unterbinden, ist es erforderlich, an der Teilfuge Dichtflächen sowohl am Unterteil als auch am Oberteil vorzusehen, zwischen denen beispielsweise ein Dichtring eingebracht ist. Durch das Vorsehen eines Flansches können das Unterteil und das Oberteil miteinander verschraubt und ein vorherbestimmter Anpressdruck der Dichtflächen gegeneinander erzeugt werden.

Die Dichtflächen sind im Betrieb der Dampfturbine Verschleißprozessen unterworfen, wie beispielsweise einer Erosionskorrosion und Belastungen durch Druck- und Temperaturgradienten. Des Weiteren kann es aufgrund von Schwingungsphänomenen im Betrieb der Dampfturbine zu einer Relativbewegung zwischen dem Unterteil und dem Oberteil kommen, wodurch es zu einer Reibkorrosion an den Dichtflächen kommen kann. Der Verschleiß und/oder die Korrosion der Dichtflächen führt zu einer Verringerung der Dichtfähigkeit, so dass letztendlich eine Leckage des Wasserdampfs eintreten kann. Herkömmlich sind sowohl das Unterteil als auch das Oberteil aus hochlegiertem und damit teurem Stahl gefertigt, um den Verschleißprozessen standzuhalten und um eine hohe Festigkeit des Unterteils und des Oberteils zu erreichen.

Dokument US 2007/284828 A1 offenbart eine Gasturbine aus zwei Komponenten, die durch eine Fuge getrennt sind.

Aufgabe der Erfindung ist es, ein Verfahren zur Herstellung einer Strömungsmaschinenkomponente mit miteinander in Linienkontakt stehenden Dichtflächen und eine Dampfturbine mit der Strömungskomponente zu schaffen, die kostengünstig herstellbar ist.

Das erfindungsgemäße Verfahren zur Herstellung einer Strömungsmaschinenkomponente weist mindestens zwei Teilkomponenten auf, die durch eine Teilfuge getrennt sind und an der Teilfuge jeweils eine Dichtfläche aufweisen, wobei mindestens eine der beiden Dichtflächen ballig ausgeführt ist, so dass ein Linienkontakt der beiden Dichtflächen ausgebildet ist, und wobei auf mindestens einer der Dichtflächen eine einen Hartstoff aufweisende, maximal 30µm dicke und mittels eines Gasphasenabscheideverfahrens aufgebrachte Beschichtung oder eine chromhaltige Legierung aufweisende Beschichtung aufweist, die maximal 30µm dick ist und mittels eines Gasphasenabscheideverfahrens aufgebracht ist oder maximal 300µm dick ist und mittels eines thermischen Spritzverfahrens aufgebracht ist.

Erfindungsgemäß wird die Beschichtung nicht porös ausgebildet. Des Weiteren ist zwischen der Beschichtung und der Teilkomponente kein zusätzlicher Schmierfilm angeordnet.

Die Teilfuge ist überall dort ausgebildet, wo zwei Teilkomponenten der Strömungsmaschinenkomponente in einem Berührungskontakt stehen. Dies kann beispielsweise bei einem zweigeteilten Gehäuse der Fall sein, ebenso ist denkbar, dass die Teilfuge zwischen einem Leitschaufelträger und dem Gehäuse ausgebildet ist. Die Strömungsmaschinenkomponente weist die chemisch resistente sowie gegen Verschleiß und/oder Erosion beständige Beschichtung auf, wodurch es vorteilhaft nicht von Nöten ist, die gesamte Strömungsmaschinenkomponente aus einem chemisch resistenten sowie gegen Verschleiß und/oder erosionsbeständigen Werkstoff herzustellen, wodurch die Herstellung der Strömungsmaschinenkomponente kostengünstig ist. Die Kombination aus dem gewählten Beschichtungsverfahren, dem dazugehörigen Beschichtungsmaterial und der angegebenen Schichtdicken führt zu einer guten Anbindung der Beschichtung an der Strömungsmaschinenkomponente, wodurch die Beschichtung für die miteinander in Linienkontakt stehenden Dichtflächen eine ausreichende Festigkeit aufweist.

Bevorzugtermaßen weist die Legierung einen Anteil von größer als 10 Massenprozent Chrom auf, insbesondere zwischen 15 und 25 Massenprozent. Des Weiteren ist es bevorzugt, dass die Legierung Nickel aufweist, insbesondere 75 bis 85 Massenprozent Nickel.

Die mittels des thermischen Spritzverfahrens aufzubringende Beschichtung weist bevorzugt Partikel aus einem Zusatzhartstoff auf. Dadurch ist die Beständigkeit der Beschichtung gegen Reibverschleiß vorteilhaft erhöht. Die Partikel sind bevorzugt keramische Partikel. Der Zusatzhartstoff weist bevorzugt ein Carbid, insbesondere Wolframcarbid, Titancarbid und/oder Chromcarbid, auf. Der Zusatzhartstoff hat bevorzugt einen Massenanteil von 70 bis 80 Massenprozent in der Beschichtung. Das thermische Spritzverfahren ist bevorzugt Hochgeschwindigkeitsflammspritzen, Kaltgasspritzen oder Detonationsspritzen.

Der Hartstoff weist bevorzugt ein Nitrid, insbesondere Chromnitrid, Titannitrid, Titanaluminiumnitrid oder ein Borid, insbesondere Titanborid, auf. Das Gasphasenabscheidungsverfahren ist bevorzugt ein Verfahren aus der Gruppe PVD (physikalische Gasphasenabscheidung, engl. physical vapour deposition) oder CVD (chemische Gasphasenabscheidung, engl. chemical vapour deposition). Die Gasphasenabscheidungsverfahren eignen sich besonders für kleine Strömungsmaschinenkomponenten.

Die erfindungsgemäße Dampfturbine weist ein geteiltes Dampfturbinengehäuse auf, das die Strömungsmaschinenkomponente ist. Das Dampfturbinengehäuse weist an seiner Teilfuge die Dichtflächen mit den Beschichtungen auf, wodurch die Dichtflächen chemisch resistent und gegen Reibverschleiß beständig sind. Durch das Vorsehen der Beschichtungen ist es vorteilhaft nicht erforderlich, das gesamte Dampfturbinengehäuse aus einem hochlegierten und teuren Werkstoff zu fertigen.

Im Folgenden wird eine bevorzugte Ausführungsform des erfindungsgemäßen Verfahrens zur Herstellung einer Strömungsmaschinenkomponente anhand der beigefügten schematischen Zeichnungen erläutert. Es zeigen:
- Figur 1: einen Querschnitt durch ein Gehäuse einer Strömungsmaschine mit einer Teilfuge und einer Detailansicht II der Teilfuge sowie
- Figur 2: die Detailansicht II aus Figur 1.

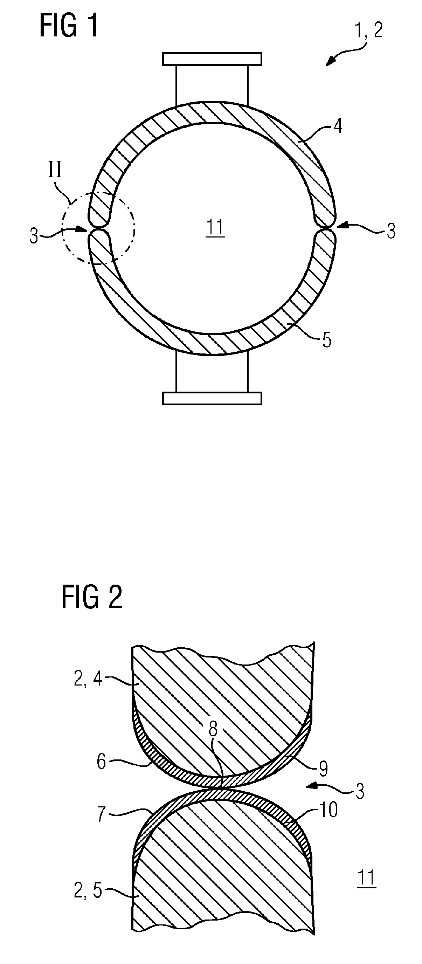

Wie es aus Figur 1 ersichtlich ist, weist eine Dampfturbine 1 als eine Strömungsmaschine ein Gehäuse 2 als eine Strömungsmaschinenkomponente auf. Innerhalb des Gehäuses 2 ist ein Fluid 11, insbesondere Wasserdampf, strömbar. Das Gehäuse 2 weist eine horizontal angeordnete Teilfuge 3 auf, die das Gehäuse 2 in eine erste Teilkomponente 4 und in eine zweite Teilkomponente 5 aufteilt. An der Teilfuge 3 weist die erste Teilkomponente 4 eine erste Dichtfläche 6 und an der zweiten Teilkomponente 5 eine zweite Dichtfläche 7 auf. Beide Dichtflächen 6, 7 sind konvex geformt, so dass die Dichtflächen 6, 7 ballig sind. Im zusammengebauten Zustand des Gehäuses 2 bilden die Dichtflächen 6, 7 an den Stellen, an denen sie aneinanderliegen, eine Kontaktlinie 8 aus. Durch das Ausbilden der Kontaktlinie 8 ist ein Austreten des Fluids 11 aus dem Gehäuse 2 unterbunden.

Die Dichtflächen 6, 7 können in der Dampfturbine 1 einer Erosionskorrosion ausgesetzt sein. Kommt es im Betrieb der Dampfturbine 1 zu Schwingungen, so können die Dichtflächen 6, 7 relativ zueinander bewegt sein, wodurch an den Dichtflächen 6, 7 eine Abrasion und/oder eine Reibkorrosion auftreten kann. Beide Korrosionsarten führen zu einem Verschleiß der Dichtflächen 6, 7, so dass es zu dem Austreten des Fluids 11 aus dem Gehäuse 2 kommen kann.

In Figur 2 ist gezeigt, dass auf der ersten Dichtfläche 6 eine erste Beschichtung 9 und auf der zweiten Dichtfläche 7 eine zweite Beschichtung 10 angebracht ist. Im Falle, dass es sich bei den Beschichtungen 9, 10 um eine thermische Spritzschicht handelt, sind die Beschichtungen 9, 10 maximal 300µm dick. Im Falle, dass die Beschichtungen 9, 10 mittels eines Gasphasenabscheidungsverfahrens aufgetragen sind, sind die Beschichtungen 9, 10 maximal 30µm dick.

Beispielsweise könnten die Beschichtungen 9, 10 200µm dick und aus einer Legierung aus 80 Massenprozent Nickel und 20 Massenprozent Chrom hergestellt sein. Die Beschichtungen 9, 10 sind dann mittels eines Kaltgasspritzens auf die Dichtflächen 6, 7 aufgebracht.

Alternativ könnten die Beschichtungen 9, 10 250µm dick und aus einer Matrix aus einer Legierung hergestellt sein, die 15 Massenprozent Chrom und 85 Massenprozent Nickel aufweist. In die Matrix sind Partikel aus Chromcarbid eingebracht, wobei die Partikel dabei einen Anteil von 75 Massenprozent an den Beschichtungen 9, 10 haben. Die Beschichtungen 9, 10 sind mittels eines Hochgeschwindigkeitsflammspritzens auf die Dichtflächen 6, 7 aufgebracht.

In einer weiteren beispielhaften Ausführungsform sind die Beschichtungen 9, 10 20µm dick und aus Chromnitrid hergestellt. Die Beschichtungen 9, 10 sind dabei mittels eines physikalischen Gasphasenabscheidungsverfahrens (PVD) auf die Dichtflächen 6, 7 aufgebracht.

Prinzipiell ist denkbar, dass die beiden Dichtflächen 6, 7 auch verschiedenartige Beschichtungen aufweisen oder nur eine der beiden Dichtflächen 6, 7 beschichtet ist. Die erste Dichtfläche 6 weist beispielsweise eine 30µm dicke Beschichtung 9 aus Titanborid auf, die mittels eines chemischen Gasphasenabscheidungsverfahrens aufgebracht ist. Die zweite Dichtfläche 7 weist beispielsweise eine 100µm dicke Schicht aus einer Legierung aus 85 Massenprozent Nickel und 15 Massenprozent Chrom auf, die mittels Detonationsspritzen aufgebracht ist.

Abweichend von der Ausführungsform aus Figuren 1 und 2 könnte die Kontaktlinie ebenfalls ausgebildet werden, wenn beispielsweise die erste Dichtfläche eben und die zweite Dichtfläche ballig ausgeführt ist. Weiterhin ist denkbar, dass die beiden Dichtflächen eben ausgeführt sind und zwischen den Dichtflächen ein Dichtring angeordnet ist, so dass zwischen den Dichtflächen und dem Dichtring jeweils eine Kontaktlinie ausgebildet ist.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Herstellung einer
Strömungsmaschinenkomponente
mit mindestens zwei Teilkomponenten (4, 5), die durch eine Teilfuge (3) getrennt sind und an der Teilfuge (3) jeweils eine Dichtfläche (6, 7) aufweisen,
wobei mindestens eine der beiden Dichtflächen (6, 7) ballig ausgeführt ist, so dass ein Linienkontakt der beiden Dichtflächen (6, 7) ausgebildet ist, und
wobei auf mindestens einer der Dichtflächen (6, 7) eine einen Hartstoff aufweisende, maximal 30µm dicke und mittels eines Gasphasenabscheideverfahrens aufgebrachte Beschichtung (9, 10) oder eine chromhaltige Legierung aufweisende Beschichtung (9, 10) aufweist, die maximal 30µm dick ist und mittels eines Gasphasenabscheideverfahrens aufgebracht ist oder maximal 300µm dick ist und mittels eines thermischen Spritzverfahrens aufgebracht ist,
wobei die Beschichtung nicht porös ausgebildet ist.

2. Verfahren nach Anspruch 1,
ohne zusätzlichen Schmierfilm zwischen der Beschichtung und der Teilkomponente (4, 5).

3. Verfahren gemäß Anspruch 1 oder 2,
wobei die Legierung einen Anteil von größer als 10 Massenprozent Chrom aufweist, insbesondere zwischen 15 und 25 Massenprozent.

4. Verfahren gemäß Anspruch 1, 2 oder 3,
wobei die Legierung Nickel aufweist, insbesondere 75 bis 85 Massenprozent Nickel.

5. Verfahren gemäß einem der Ansprüche 1 bis 4,
wobei die mittels des thermischen Spritzverfahrens aufzubringende Beschichtung (9, 10) Partikel aus einem Zusatzhartstoff aufweist.

6. Verfahren gemäß Anspruch 5,
wobei die Partikel keramische Partikel sind.

7. Verfahren gemäß Anspruch 5 oder 6,
wobei der Zusatzhartstoff ein Carbid, insbesondere Wolframcarbid, Titancarbid und/oder Chromcarbid, aufweist.

8. Verfahren gemäß einem der Ansprüche 5 bis 7,
wobei der Zusatzhartstoff einen Massenanteil von 70 bis 80 Massenprozent in der Beschichtung (9, 10) hat.

9. Verfahren gemäß einem der Ansprüche 1 bis 8,
wobei das thermische Spritzverfahren Hochgeschwindigkeitsflammspritzen, Kaltgasspritzen oder Detonationsspritzen ist.

10. Verfahren gemäß Anspruch 1,
wobei der Hartstoff ein Nitrid, insbesondere Chromnitrid, Titannitrid, Titanaluminiumnitrid oder ein Borid, insbesondere Titanborid, aufweist.

11. Verfahren gemäß Anspruch 1 oder 10,
wobei das Gasphasenabscheidungsverfahren ein Verfahren aus der Gruppe PVD (physikalische Gasphasenabscheidung, engl. physical vapour deposition) oder CVD (chemische Gasphasenabscheidung, engl. chemical vapour deposition) ist.

12. Dampfturbine mit einem geteilten Dampfturbinengehäuse, das die Strömungsmaschinenkomponente (1) gemäß einem der Ansprüche 1 bis 11 ist.

## Claims

1. Process for producing a turbomachine component having at least two sub-components (4, 5) which are separated by means of a parting joint (3) and have in each case a sealing surface (6, 7) at the parting joint (3), wherein at least one of the two sealing surfaces (6, 7) is crowned, so as to form a linear contact between the two sealing surfaces (6, 7), and
wherein at least one of the sealing surfaces (6, 7) is provided with a coating (9, 10) which has a hard material, is at most 30 µm thick and which is applied by means of a gas phase deposition method, or a coating (9, 10) which has a chromium-containing alloy, which is at most 30 µm thick and is applied by means of a gas phase deposition method or which is at most 300 µm thick and is applied by means of a thermal spraying method,
wherein the coating is formed such that it is not porous.

2. Process according to Claim 1,
without an additional lubricating film between the coating and the sub-component (4, 5).

3. Process according to Claim 1 or 2, wherein the chromium fraction in the alloy is greater than 10% by mass, in particular between 15 and 25% by mass.

4. Process according to Claim 1, 2 or 3,
wherein the alloy comprises nickel, in particular 75 to 85% by mass of nickel.

5. Process according to one of Claims 1 to 4,
wherein the coating (9, 10) which is to be applied by means of the thermal spraying method comprises particles of an additional
hard material.

6. Process according to Claim 5,
wherein the particles are ceramic particles.

7. Process according to Claim 5 or 6,
wherein the additional hard material comprises a carbide, in particular tungsten carbide, titanium carbide and/or chromium carbide.

8. Process according to one of Claims 5 to 7,
wherein the additional hard material has a proportion by mass of 70 to 80% by mass in the coating (9, 10).

9. Process according to one of Claims 1 to 8,
wherein the thermal spraying method is high velocity oxygen fuel spraying, cold gas spraying or detonation spraying.

10. Process according to Claim 1,
wherein the hard material comprises a nitride, in particular chromium nitride, titanium nitride, titanium aluminum nitride or a boride, in particular titanium boride.

11. Process according to Claim 1 or 10,
wherein the gas phase deposition method is a method from the group PVD (physical vapor deposition) or CVD (chemical vapor deposition).

12. Steam turbine having a split steam turbine housing, which is the turbomachine component (1) according to one of Claims 1 to 11.

## Revendications

1. Procédé de fabrication d'un élément de turbomachine ayant au moins deux sous-éléments (4, 5) qui sont séparés par un joint (3) et qui ont sur le joint (3) respectivement une surface (6, 7) d'étanchéité,
dans lequel au moins l'une des deux surfaces (6, 7) d'étanchéité est bombée de manière à former un contact linéaire des deux surfaces (6, 7) d'étanchéité et
dans lequel, sur au moins l'une des surfaces (6, 7) d'étanchéité, il y a un revêtement (9, 10) ayant une substance dure d'une épaisseur maximum de 30 µm et déposée au moyen d'un procédé de dépôt en phase gazeuse ou un revêtement (9, 10) ayant un alliage de chrome, qui a une épaisseur de 30 µm au maximum et qui est déposé au moyen d'un procédé de dépôt en phase gazeuse ou qui a une épaisseur de 30 µm au maximum et qui est déposé au moyen d'un procédé de pulvérisation thermique,
le revêtement n'était pas poreux.

2. Procédé suivant la revendication 1,
sans pellicule lubrifiante supplémentaire entre le revêtement et les sous-éléments (4, 5).

3. Procédé suivant la revendication 1 ou 2,
dans lequel l'alliage a une proportion plus grande que 10 % en masse de chrome, notamment comprise entre 15 et 25 % en masse.

4. Procédé suivant la revendication 1, 2 ou 3,
dans lequel l'alliage comporte du nickel, notamment de 75 à 85 % en masse de nickel.

5. Procédé suivant l'une des revendications 1 à 4,
dans lequel le revêtement (9, 10) à déposer au moyen du procédé de pulvérisation thermique comporte des particules en une substance dure supplémentaire.

6. Procédé suivant la revendication 5,
dans lequel les particules sont des particules de céramique.

7. Procédé suivant la revendication 5 ou 6,
dans lequel la substance dure supplémentaire comporte un carbure, notamment du carbure de tungstène, du carbure de titane et/ou du carbure de chrome.

8. Procédé suivant l'une des revendications 5 à 7,
dans lequel la substance dure supplémentaire a une proportion en masse de 70 à 80 % en masse dans le revêtement (9, 10).

9. Procédé suivant l'une des revendications 1 à 8,
dans lequel le procédé de pulvérisation thermique est une pulvérisation à la flamme à grande vitesse, une pulvérisation au gaz froid ou une pulvérisation par détonnation.

10. Procédé suivant la revendication 1,
dans lequel la substance dure comporte un nitrure, notamment du nitrure de chrome, du nitrure de titane, du nitrure de titane et d'aluminium ou un borure, notamment du borure de titane.

11. Procédé suivant la revendication 1 ou 10,
dans lequel le procédé de dépôt en phase gazeuse est un procédé choisi dans le groupe (PVD) (dépôt physique en phase gazeuse, en anglais physical vapour déposition) ou CVD (dépôt chimique en phase gazeuse, en anglais chemical vapour deposition).

12. Turbine à vapeur ayant une carcasse de turbine à vapeur, qui est divisée et qui est l'élément (1) de turbomachine suivant l'une des revendications 1 à 11.
